# EUROPÄISCHE PATENTSCHRIFT

(11) **EP 2 714 417 B1**
(45) Veröffentlichungstag und Bekanntmachung des Hinweises auf die Patenterteilung: **01.04.2015**
(21) Anmeldenummer: 12755997.9
(22) Anmeldetag: 03.09.2012
(51) Int. Cl.: B41N 1/24, H05K 3/12, B41F 35/00, B41M 1/12

(54) **VERFAHREN ZUM BESCHICHTEN VON SIEBDRUCKSCHABLONEN**
METHOD FOR COATING SILK-SCREEN PRINTING STENCILS
PROCÉDÉ DE REVÊTEMENT DE STENCILS POUR SÉRIGRAPHIE

(30) Priorität: 29.09.2011 DE 102011083733
(43) Veröffentlichungstag der Anmeldung: 09.04.2014
(73) Patentinhaber: Siemens Aktiengesellschaft, 80333 München (DE)
(72) Erfinder: EDER, Florian, 91052 Erlangen (DE); ZEININGER, Heinrich, 90587 Obermichelbach (DE)
(86) Internationale Anmeldenummer: PCT/EP2012/067104
(87) Internationale Veröffentlichungsnummer: WO 2013/045207

(56) Entgegenhaltungen:
- EP-A2- 0 220 121
- DE-A1-102005 045 350
- DE-A1-102007 010 936

## Beschreibung

Die vorliegende Erfindung betrifft Verfahren zum Beschichten von Siebdruckschablonen, insbesondere mit Anti-Haft-Beschichtungen für Lotpasten.

### Stand der Technik

Oberflächenbestückung von Leiterplatten umfasst eine Abfolge komplexer Fertigungsprozesse, bei denen unter anderem verschiedene Substanzen auf der Leiterplatte aufgebracht werden. Aufgrund der fortschreitenden Miniaturisierung kommen verstärkt hochviskose und zäh-klebrige Substanzen wie beispielsweise Lotpasten zum Einsatz, die im pastösen Zustand auf der Leiterplatte die nötige Formstabilität gewährleistet.

Zur Aufbringung in der Oberflächenbestückung (SMT, "surface mounting technology") werden häufig Siebdruckverfahren verwendet, mithilfe derer Leiterplatten mittels einer Siebdruckschablone gemäß einer vorgegebenen Druckstruktur an bestimmten Stellen mit einer Druck- oder Lotpaste oder mit einem Kleber versehen werden. Dabei wird die Lotpaste bzw. die Kleberpaste mit einem Rakel durch der Druckstruktur entsprechende Ausnehmungen eines metallischen Schablonenkörpers hindurch auf die jeweilige Leiterplatte aufgebracht. Die so entstehenden Pastenbereiche bilden Pads, auf welche elektronische Komponenten beispielsweise mit einer Bestückungsmaschine ("Pick & Place"-Automat) aufgebracht und fixiert werden.

Siebdruckschablonen können dabei im Wesentlichen aus einem formsteifen Rahmen bestehend, auf den ein feines Metalldrahtgewebe unter Vorspannung aufgeklebt ist. In einem mittleren Bereich dieses Metalldrahtgewebes ist eine das Druckmuster aus den Ausnehmungen aufweisende, dünnwandige Metallschablone befestigt.

Die Siebdruckschablonen müssen dabei entsprechend der Miniaturisierung der elektronischen Komponenten verkleinert werden. Hierbei ergibt sich die Gefahr, dass Löt- oder Klebepunkte oder Pastendepots an den durch das jeweilige Druckmuster bestimmten Öffnungsrändern oder -wänden des als Schablonenmaterial verwendeten Metalls anhaften, so dass die entsprechenden Ausnehmungen sukzessive zuwachsen können. Dies wiederum hat häufig ein Aus- oder Einreißen der Außenränder der auf die Leiterplatte aufgebrachten Pads beim Abheben der Druckschablone zur Folge. Die Anforderungen hinsichtlich eines gewünschten konturenscharfen Druckbildes auf der Leiterplatte können dann unter Umständen nicht mehr erfüllt werden.

Die Druckschrift DE 10 2005 045 350 A1 offenbart ein Verfahren zur nasschemischen Beschichtung von Druckschablonen mit Anti-Haft-Beschichtungen aus metallalkoxidischen Beschichtungsmaterialien, beispielsweise in Sol-Gel-Prozessen.

Die Druckschrift DE 102 31 698 A1 offenbart ein Verfahren zur Beschichtung von Druckschablonen mit einer Anti-Haft-Beschichtung aus siloxan- oder kohlenwasserstoffbasierten Schichten in einem Niederdruckplasmaprozess.

Die Druckschrift DE 10 2007 010 936 A1 offenbart eine Siebdruckschablone mit einer nanokristallinen Anti-Haft-Beschichtung.

Es besteht ein Bedarf an chemisch und mechanisch stabilen, häufig wiederverwendbaren und leicht zu reinigenden Siebdruckschablonen und entsprechenden Fertigungsverfahren für derartige Siebdruckschablonen.

### Zusammenfassung der Erfindung

Ein Beispiel besteht daher in einer Siebdruckschablone, mit einem Schablonenkörper, wobei der Schablonenkörper eine Oberflächenbeschichtung aus kohlenwasserstoffbasierten, organischen Präkursormolekülen (auch Precursor-Moleküle genannt) aufweist.

Eine wesentliche Idee der Erfindung besteht darin, eine Anti-Haft-Beschichtung für Siebdruckschablonen zu schaffen, welche zugleich gute Anti-Haft-Eigenschaften gegenüber pastösen Druckmaterialien bietet und gleichzeitig durch einen einfach zu implementierenden und kostengünstigen Prozess aufzubringen ist. Darüber hinaus bietet sich der zusätzliche Vorteil, dass sich die Oberflächenbeschichtung in einem mit dem Aufbringungsprozess sehr gut kompatiblen Reinigungsprozess wieder rückstandsfrei ablösen lässt, wodurch sich die Wiederverwendbarkeit der Siebdruckschablone bei gleichzeitig qualitativ auf hohem Niveau bleibenden Druckeigenschaften erheblich verbessern lässt.

Gemäß einer Ausführungsform können die Präkursormoleküle Ethan, Acetylen, Methan, Cycloaromaten, teilfluorierte Kohlenwasserstoffe und/oder Mischungen dieser Moleküle umfassen. Dadurch kann die Oberflächenbeschichtung eine Anti-HaftWirkung gegenüber pastösen Druckmaterialien, wie beispielsweise Lotpasten oder Klebepasten entfalten. Zugleich kann die Oberflächenbeschichtung vorteilhafterweise in einem Plasmareinigungsprozess wieder von der Siebdruckschablone abgelöst werden, so dass eine Neubeschichtung der Siebdruckschablone in einfacher Weise möglich bleibt.

Gemäß einer Ausführungsform kann der Schablonenkörper eine Vielzahl von Ausnehmungen aufweisen, welche dazu ausgelegt sind, ein Druckmaterial in einer vorbestimmten Druckstruktur durch die Siebdruckschablone auf eine zu bedruckende Leiterplatte zu führen. Für derartige Siebdruckschablonen ist die Oberflächenbeschichtung besonders geeignet, da die Oberflächenbeschichtung in einem Plasmaprozess auf den Schablonenkörper aufgebracht werden kann, wodurch auch Kanten und Strukturmuster der Siebdruckschablone gleichmäßig beschichtet werden können, was wiederum die Prozesssicherheit des Siebdruckprozesses verbessert.

Gemäß einer Ausführungsform kann die Oberflächenbeschichtung die Innenwände der Ausnehmungen mit einer homogenen Schichtdicke bedecken. Dies bietet den Vorteil, dass ein besonders konturenscharfer Siebdruck mit der Siebdruckschablone möglich wird.

Die vorliegende Erfindung schafft gemäß einem Aspekt ein Verfahren zum Beschichten einer Siebdruckschablone, mit dem Schritt des Abscheidens einer Schicht aus kohlenwasserstoffbasierten, organischen Präkursormolekülen auf der Oberfläche eines Schablonenkörpers der Siebdruckschablone mithilfe einer Plasmabeschichtungsanlage, insbesondere einer Atmosphärendruckplasmabeschichtungsanlage. Dieses Verfahren zeichnet gegenüber nasschemischen Prozessen dadurch aus, dass die Benetzungsproblematik reduziert wird. Das Verfahren gewährleistet gute Schichteigenschaften, beispielsweise eine geringe Anfälligkeit gegenüber mechanischem Stress, eine gute Hydrolysebeständigkeit und eine hohe Beständigkeit gegenüber Lösungsmitteln. Schließlich kann vorteilhafterweise auf den Einsatz von Lösemitteln oder Tensiden sowie auf eine thermische Härtung der Präkursormolekülschicht verzichtet werden.

Gemäß einer Ausführungsform kann vor dem Schritt des Abscheidens der Schritt des Reinigens des Schablonenkörpers der Siebdruckschablone von Druckmaterialresten und/oder organischen Verunreinigungen mithilfe eines Plasmas der Plasmabeschichtungsanlage durchgeführt werden. Dies bietet den Vorteil, dass Neubeschichtung und vorangehende Reinigung der Siebdruckschablone in einer einzigen Plasmaanlage durchgeführt werden können, was zu erheblicher Zeit- und Kostenersparnis führt.

Gemäß einer Ausführungsform kann der Schritt des Reinigens unter Verwendung von Sauerstoff, Druckluft oder Formiergas als Prozessgas durchgeführt wird. Dadurch können nicht nur organische Verunreinigungen entfernt, sondern auch anorganische Partikel durch den Prozessgasstrom und die im Plasma auftretende Neutralisierung der Oberflächenpartialladungen in einfacher und effektiver Weise abgeblasen werden.

Gemäß einer Ausführungsform kann im Schritt des Reinigens eine bereits auf dem Schablonenkörper vorhandene Oberflächenbeschichtung entfernt werden. Dadurch kann sichergestellt werden, dass bei jeder Reinigung eine frische Oberflächenbeschichtung aufgetragen werden kann, was die Verlässlichkeit der Siebdruckschablone beim Drucken und damit die Prozesssicherheit erheblich verbessern kann.

Erfindungsgemäß wird der Schablonenkörper im Schritt des Abscheidens auf einer Temperatur von unter 10°C gehalten. Einerseits können dadurch die Abscheideraten erhöht, und andererseits die strukturellen chemischen Eigenschaften der abgeschiedenen Schicht verbessert werden.

Gemäß einer Ausführungsform kann der Schritt des Abscheidens unter Verwendung von Formiergas oder einer anderen Wasserstoff-Argon-Mischung als Ionisationsgas durchgeführt werden.

Gemäß einer Ausführungsform kann der Schritt des Abscheidens unter Atmosphärendruck durchgeführt werden. Dies ist besonders zweckmäßig, da eine Plasmabeschichtung unter Atmosphärendruck besonders effizient und kostengünstig durchzuführen ist.

Die vorliegende Erfindung schafft gemäß einem weiteren Aspekt eine Druckschablonenreinigungsanlage, welche dazu ausgelegt ist, ein erfindungsgemäßes Verfahren zum Beschichten einer Siebdruckschablone durchzuführen.

Weitere Modifikationen und Variationen ergeben sich aus den Merkmalen der abhängigen Ansprüche.

### Kurze Beschreibung der Figuren

Verschiedene Ausführungsformen und Ausgestaltungen der vorliegenden Erfindung werden nun in Bezug auf die beiliegenden Zeichnungen genauer beschrieben, in denen
Fig. 1 eine schematische Darstellung einer Siebdruckschablone gemäß einem Aspekt der Erfindung;
Fig. 2 eine schematische Darstellung eines Ausschnitts einer Siebdruckschablone gemäß einem weiteren Aspekt der Erfindung; und
Fig. 3 eine schematische Darstellung eines Verfahrens zum Beschichten einer Siebdruckschablone gemäß einem weiteren Aspekt der Erfindung zeigt.

Die beschriebenen Ausgestaltungen und Weiterbildungen lassen sich, sofern sinnvoll, beliebig miteinander kombinieren. Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmale der Erfindung.

Die beiliegenden Zeichnungen sollen ein weiteres Verständnis der Ausführungsformen der Erfindung vermitteln. Sie veranschaulichen Ausführungsformen und dienen im Zusammenhang mit der Beschreibung der Erklärung von Prinzipien und Konzepten der Erfindung. Andere Ausführungsformen und viele der genannten Vorteile ergeben sich im Hinblick auf die Zeichnungen. Die Elemente der Zeichnungen sind nicht notwendigerweise maßstabsgetreu zueinander gezeigt. Gleiche Bezugszeichen bezeichnen dabei gleiche oder ähnlich wirkende Komponenten.

### Ausführliche Beschreibung der Erfindung

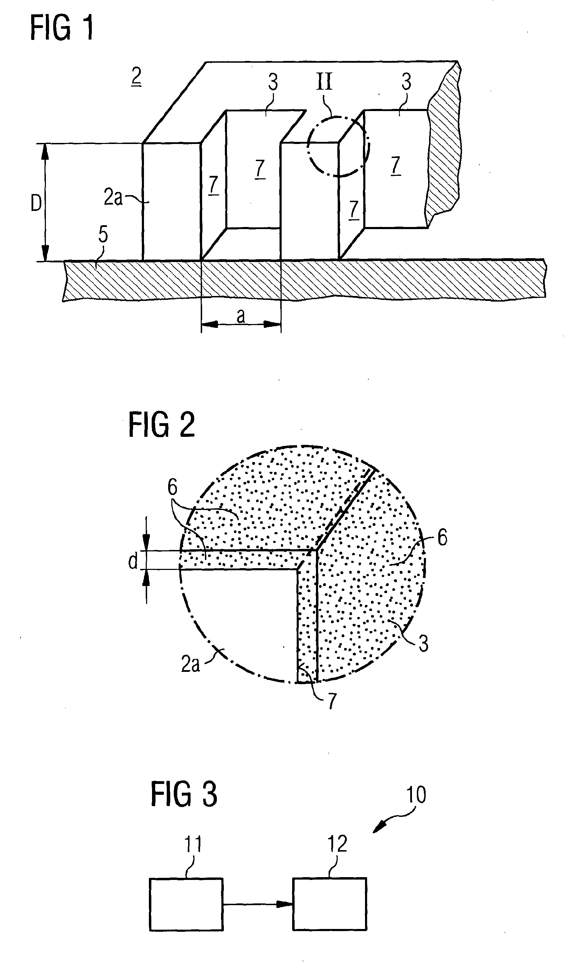

Fig. 1 zeigt eine schematische Darstellung einer Siebdruckschablone 2. Die Siebdruckschablone 2 weist einen Schablonenkörper 2a auf, welcher beispielsweise aus einem Stahl wie insbesondere einem Edelstahl, zum Beispiel einem CrNi-Stahl, oder aus Ni oder einer anderen Ni-Legierung bestehen kann.

Die Dicke D des Schablonenkörpers 2a kann beispielsweise zwischen 100 und 5000 µm liegen.

In den Schablonenkörper 2a können zum Beispiel mittels Lasertechnologie oder galvanoplastischer Verfahren Ausnehmungen 3 oder sonstige Durchbrüche bzw. Aperturen eingearbeitet sein. Die maximale Abmessung a dieser Ausnehmungen 3 kann beispielsweise zwischen 200 µm und 500 µm, beispielsweise bei etwa 300 µm liegen. Die maximale Abmessung a hängt von der gewünschten Größe des auf einer darunter liegenden Leiterplatte 5 aufzubringenden Pads bzw. Kontaktierungsfläche aus einem Druckmaterial wie insbesondere einer Lot- oder Klebepaste ab. Die Form der Ausnehmungen 3 kann dabei von einem auf die Leiterplatte 5 aufzubringenden Druckmuster abhängig sein. Das Druckmuster kann dabei dazu ausgelegt sein, ein Druckmaterial in einer vorbestimmten Struktur durch die Siebdruckschablone 2 auf die zu bedruckende Leiterplatte 5 zu führen.

Die Siebdruckschablone 2 wird für den Druckprozess auf die Leiterplatte 5 aufgedrückt. Von der offenen Seite der Ausnehmungen 3 her wird dann eine Lot- oder Klebepaste mittels einer über die freie Oberfläche der Siebdruckschablone 2 hinweg streichenden Rakels eingebracht. Damit sich nach diesem Druckprozess beim anschließenden Abheben der Siebdruckschablone 2 von der Leiterplatte 5 die Lot- oder Klebepaste gut von der Siebdruckschablone 2, insbesondere von den Innenwänden 7 ihrer Ausnehmungen 3 lösen kann, ist der Schablonenkörper 2a vollständig oder zumindest bereichsweise mit einer Oberflächenbeschichtung 6 versehen, wie in Fig. 2 schematisch für einen in Fig. 1 mit II bezeichneten Ausschnitt gezeigt.

Die Oberflächenbeschichtung 6 wirkt gegenüber einer Lot- oder Klebepaste anti-haftend, das heißt, das Abreißverhalten an den Innenwänden 7 der Ausnehmungen 3 der Siebdruckschablone 2 wird durch die Oberflächenbeschichtung 6 verringert bzw. unterdrückt. Dabei kann die Oberflächenbeschichtung 6 aus kohlenwasserstoffbasierten, organischen Präkursormolekülen aufgebaut sein. Derartige Präkursormoleküle können beispielsweise Ethan, Acetylen, Methan, Cycloaromaten, Ethylbenzol teilfluorierte Kohlenwasserstoffe und/oder Mischungen dieser Moleküle umfassen. Eine mögliche Mischung für die Oberflächenbeschichtung 6 kann beispielsweise eine Mischung aus Acetylen und Methan umfassen.

Die Schichtdicke d der Oberflächenbeschichtung 6 kann beispielsweise zwischen 50 nm und 1000 nm betragen. Dabei ist es vorteilhaft, wenn die Schichtdicke d insbesondere im Bereich der Innenwände 7 der Ausnehmungen 3 sowie deren Kanten und Ecken homogen auf dem Schablonenkörper 2a aufgebracht ist, das heißt, eine konforme Oberflächenbeschichtung 6 auf dem Schablonenkörper 2a aufgebracht ist. Dadurch erhöht sich die Konturenschärfe des Druckprozesses mit der Siebdruckschablone 2.

Fig. 3 zeigt eine schematische Darstellung eines Verfahrens 10 zum Beschichten einer Siebdruckschablone, insbesondere einer Siebdruckschablone 2 der Fig. 1 und 2. Das Verfahren 10 kann beispielsweis'e ein Plasmabeschichtungsverfahren sein, welches in einer Plasmabeschichtungsanlage unter Atmosphärendruck durchgeführt werden kann. Beispielsweise kann das Verfahren 10 in einer Atmosphärendruckplasmaanlage (Plasmatreat AS400) bei einer Plasmafrequenz von unter 22 kHz, mit einer Plasmazykluszeit von unter 30% und der Verwendung von Druckluft, Formiergas oder einer Wasserstoff-Argon-Mischung als Prozessgas durchgeführt werden.

In einem optionalen Schritt 11 kann zunächst ein Reinigen des Schablonenkörpers der Siebdruckschablone von Druckmaterialresten und/oder organischen Verunreinigungen wie Flussmittelresten mithilfe eines Plasmas der Plasmabeschichtungsanlage durchgeführt werden. Beispielsweise können mit dem Reinigungsschritt 11 alle organischen und anorganischen Verunreinigungen entfernt werden. Dazu kann beispielsweise Sauerstoff, Druckluft, Formiergas oder eine Wasserstoff-Argon-Mischung verwendet werden, so dass in dem starken Luftstrom die entsprechenden Feststoffpartikel einfach weggeblasen werden. Das Reinigen einer Siebdruckschablone, welche mit einer Oberflächenbeschichtung beschichtet ist, kann dabei erheblich einfacher und schneller durchgeführt werden, als das Reinigen einer unbeschichteten Siebdruckschablone.

Je nach Einstellung der Plasmaflamme kann im Schritt 11 gleichzeitig auch die Oberflächenbeschichtung mit entfernt werden, so dass nach dem Schritt 11 wieder eine von allen Molekülen befreite Siebdruckschablone vorliegt.

In einem Schritt 12 erfolgt dann ein Abscheiden einer Schicht aus kohlenwasserstoffbasierten, organischen Präkursormolekülen auf der Oberfläche des gegebenenfalls gereinigten Schablonenkörpers der Siebdruckschablone mithilfe der gleichen Plasmabeschichtungsanlage, die gegebenenfalls zum Reinigen der Siebdruckschablone eingesetzt worden ist. Dies bietet eine erhöhte Effizienz in der Prozesskette, da die Siebdruckschablonen nicht in eine andere Anlage umgesetzt werden müssen.

Die Plasmadüse, die beispielsweise mit einem eingebauten Potentialgitter versehen sein kann, kann dazu auf Beschichtungsbetrieb umgestellt werden, das heißt, bei Zugabe von Präkursormolekülen in das Plasma werden diese als polymere Anti-Haft-Beschichtung auf der Oberfläche des Schablonenkörpers abgeschieden. Diese Abscheidung bietet daher den Vorteil einer gleichmäßigen Abscheidung auch an Innenwänden, Kanten und Ecken der Ausnehmungen in der Siebdruckschablone. Der Schritt 12 des Abscheidens kann beispielsweise auch vorgenommen werden, wenn eine Siebdruckschablone aufgrund von Layoutänderungen des Druckmusters gerade angepasst worden ist und daher neu beschichtet werden muss. Die Oberflächenbeschichtung der Siebdruckschablone kann bei der Verwendung von Ethyl-Benzol als Präkursormolekülen beispielsweise einen Kontaktwinkel von etwa 105° und eine Hysterese von 8° aufweisen.

Der Schritt 12 des Abscheidens kann beispielsweise mit Formiergas oder einer anderen Wasserstoff-Argon-Mischung als Ionisationsgas durchgeführt werden. Beispielsweise kann dazu Varigon® (Linde) eingesetzt werden. Weiterhin kann die Siebdruckschablone während dem Abscheiden auf eine Temperatur unter 50°C, insbesondere unter 10°C gekühlt werden. Als Prozessparameter können dabei bevorzugt Prozesswerte gewählt werden, die einen geringen Energieeintrag in die Plasmaflamme gewährleisten, um die Präkursormoleküle nicht zu verbrennen.

Die Erfindung betrifft ein Plasmabeschichtungsverfahren zum Beschichten einer Siebdruckschablone, wobei eine Schicht aus kohlenwasserstoffbasierten, organischen Präkursormolekülen auf der Oberfläche des Schablonenkörpers der Siebdruckschablone abgeschieden wird.

## Patentansprüche

1. Verfahren (10) zum Beschichten einer Siebdruckschablone (2), mit dem Schritt:
Abscheiden (12) einer Schicht (6) aus kohlenwasserstoffbasierten, organischen Präkursormolekülen auf der Oberfläche eines Schablonenkörpers (2a) der Siebdruckschablone (2) mithilfe einer Plasmabeschichtungsanlage, insbesondere einer Atmosphärendruckplasmabeschichtungsanlage,
wobei der Schablonenkörper (2a) im Schritt des Abscheidens (12) auf einer Temperatur von unter 10°C gehalten wird.

2. Verfahren (10) nach Anspruch 1, weiterhin mit dem vor dem Schritt des Abscheidens (12) durchzuführenden Schritt:
Reinigen (11) des Schablonenkörpers (2a) der Siebdruckschablone (2) von Druckmaterialresten und/oder organischen Verunreinigungen mithilfe eines Plasmas der Plasmabeschichtungsanlage.

3. Verfahren (10) nach Anspruch 2, wobei der Schritt des Reinigens (11) unter Verwendung von Druckluft oder Formiergas als Prozessgas durchgeführt wird.

4. Verfahren (10) nach einem der Ansprüche 2 und 3, wobei im Schritt des Reinigens (11) eine bereits auf dem Schablonenkörper (2a) vorhandene Oberflächenbeschichtung (6) aus kohlenwasserstoffbasierten, organischen Präkursormolekülen entfernt wird.

5. Verfahren (10) nach einem der Ansprüche 1 bis 4, wobei die Präkursormoleküle Ethan, Acetylen, Methan, Cycloaromaten, teilfluorierte Kohlenwasserstoffe und/oder Mischungen dieser Moleküle umfassen.

6. Verfahren (10) nach einem der Ansprüche 1 bis 5, wobei Schritt des Abscheidens (12) unter Verwendung von Formiergas oder einer anderen Wasserstoff-Argon-Mischung als Ionisationsgas durchgeführt wird.

7. Verfahren (10) nach einem der Ansprüche 1 bis 6, wobei Schritt des Abscheidens (12) unter Atmosphärendruck durchgeführt wird.

8. Druckschablonenreinigungsanlage, eine Plasmabeschichtungsanlage umfassend, wobei die Druckschablonenreinigungsanlage über Mittel verfügt, die einen im Plasmareaktor befindlichen Schablonenkörper auf Temperaturen unter 10°C kühlen.

## Claims

1. Method (10) of coating a screen printing stencil (2), comprising the step of:
depositing (12) a layer (6) of hydrocarbon-based, organic precursor molecules on the surface of a stencil body (2a) of the screen printing stencil (2) using a plasma coating apparatus, in particular an atmospheric pressure plasma coating apparatus,
wherein the stencil body (2a) is maintained at a temperature of below 10°C in the depositing step (12).

2. Method (10) according to Claim 1, further comprising a step to be carried out before the depositing step (12), said further step comprising:
cleaning (11) the stencil body (2a) of the screen printing stencil (2) of printing material residues and/or organic impurities using a plasma from the plasma coating apparatus.

3. Method (10) according to Claim 2, wherein the step of cleaning (11) is carried out by using compressed air or forming gas as process gas.

4. Method (10) according to either of Claims 2 and 3, wherein the step of cleaning (11) removes a surface coating (6) of hydrocarbon-based, organic precursor molecules which is already present on the stencil body (2a).

5. Method (10) according to any of Claims 1 to 4, wherein the precursor molecules include ethane, acetylene, methane, cycloaromatics, partially fluorinated hydrocarbons and/or mixtures thereof.

6. Method (10) according to any of Claims 1 to 5, wherein the step of depositing (12) is carried out by using forming gas or some other hydrogen-argon mixture as ionization gas.

7. Method (10) according to any of Claims 1 to 6, wherein the step of depositing (12) is carried out under atmospheric pressure.

8. Printing stencil cleaning apparatus comprising a plasma coating apparatus, wherein the printing stencil cleaning apparatus has means for cooling a stencil body located in the plasma reactor to temperatures below 10°C.

## Revendications

1. Procédé (10) de revêtement d'un pochoir sérigraphique (2), comprenant l'étape suivante :
dépôt (12) d'une couche (6) de molécules de précurseurs organiques à base d'hydrocarbures sur la surface d'un corps (2a) de pochoir du pochoir sérigraphique (2) à l'aide d'une installation de revêtement par plasma, en particulier une installation de revêtement par plasma à pression atmosphérique,
à l'étape du dépôt (12) le corps (2a) de pochoir étant maintenu à une température inférieure à 10°C.

2. Procédé (10) selon la revendication 1, comprenant en outre l'étape suivante à effectuer avant l'étape du dépôt (12) :
nettoyage (11) du corps (2a) de pochoir du pochoir sérigraphique (2) pour éliminer des restes de matière d'impression et/ou des contaminants organiques à l'aide d'un plasma de l'installation de revêtement par plasma.

3. Procédé (10) selon la revendication 2, l'étape du nettoyage (11) étant effectuée en utilisant de l'air comprimé ou un gaz de formage comme gaz de process.

4. Procédé (10) selon l'une des revendications 2 et 3, à l'étape du nettoyage (11) un revêtement de surface (6) déjà présent sur le corps (2a) de pochoir de molécules de précurseurs organiques à base d'hydrocarbures étant éliminé.

5. Procédé (10) selon l'une des revendications 1 à 4, les molécules de précurseurs comprenant l'éthane, l'acétylène, le méthane, les cycloaromates, les hydrocarbures partiellement fluorés et/ou des mélanges de ces molécules.

6. Procédé (10) selon l'une des revendications 1 à 5, l'étape du dépôt (12) étant effectuée en utilisant un gaz de formage ou un autre mélange hydrogène-argon comme gaz d'ionisation.

7. Procédé (10) selon l'une des revendications 1 à 6, l'étape du dépôt (12) étant effectuée sous pression atmosphérique.

8. Installation de nettoyage de pochoirs d'impression comprenant une installation de revêtement par plasma, l'installation de nettoyage de pochoirs d'impression disposant de moyens qui refroidissent un corps de pochoir se trouvant à l'intérieur du réacteur à plasma à des températures inférieures à 10°C.
